# EUROPÄISCHE PATENTSCHRIFT

(11) **EP 3 340 268 B1**
(45) Veröffentlichungstag und Bekanntmachung des Hinweises auf die Patenterteilung: **10.11.2021**
(21) Anmeldenummer: 17206506.2
(22) Anmeldetag: 11.12.2017
(51) Int. Cl.: H01H 47/00, G05B 9/02

(54) **SICHERHEITSSCHALTANORDNUNG ZUM FEHLERSICHEREN ABSCHALTEN EINER ELEKTRISCH ANGETRIEBENEN ANLAGE**
SAFETY CIRCUIT FOR THE FAIL-SAFE SHUTDOWN OF AN ELECTRICALLY POWERED SYSTEM
SYSTÈME DE COMMUTATION DE SÉCURITÉ PERMETTANT DE COUPER SANS DÉFAUTS UNE INSTALLATION ENTRAINÉE DE MANIÈRE ÉLECTRIQUE

(30) Priorität: 20.12.2016 DE 102016125031
(43) Veröffentlichungstag der Anmeldung: 27.06.2018
(73) Patentinhaber: Pilz GmbH & Co. KG, 73760 Ostfildern (DE)
(72) Erfinder: Pullmann, Jürgen, 73760 Ostfildern (DE)
(74) Vertreter: Witte, Weller & Partner Patentanwälte mbB

(56) Entgegenhaltungen:
- EP-A1- 2 383 762
- EP-A2- 2 983 187
- DE-U1- 9 414 079

## Beschreibung

Die vorliegende Erfindung betrifft eine Sicherheitsschaltungsanordnung zum fehlersicheren Abschalten einer elektrisch angetriebenen Anlage mit einem Sicherheitsschaltgerät und einem Meldegerät. Ebenso betrifft die vorliegende Erfindung ein entsprechendes Sicherheitsschaltgerät sowie ein entsprechendes Meldegerät.

Eine Sicherheitsschaltungsanordnung im Sinne der vorliegenden Erfindung ist eine Schaltungsanordnung mit zumindest zwei funktionsbestimmenden Komponenten, die zusammenwirken, um den gefährlichen Betrieb einer technischen Anlage abzusichern, das heißt um Unfälle zu vermeiden, die die Gesundheit oder das Leben von Personen im Bereich der Anlage gefährden. Die eine Komponente ist ein Sicherheitsschaltgerät, das speziell dazu ausgebildet ist, einen Stromversorgungspfad zu der Anlage fehlersicher zu unterbrechen, um die Anlage in einen ungefährlichen, stromlosen Zustand zu bringen.

Wichtig ist, dass ein Sicherheitsschaltgerät selbst dann einen sicheren Anlagenbetriebszustand gewährleistet, wenn Fehler auftreten, etwa wenn elektronische Bauteile versagen, eine Leitungsverbindung beschädigt wird oder ein anderes Fehlereignis auftritt. Dementsprechend sind Sicherheitsschaltgeräte in der Regel mehrkanalig redundant aufgebaut. Komplexere Sicherheitsgeräte können zudem interne Überwachungsfunktionen besitzen, um einzelne Fehler frühzeitig zu erkennen und eine Anhäufung von Fehlern zu vermeiden.

Die zweite Komponente ist ein Meldegerät oder Sensor, welche mit dem Sicherheitsschaltgerät gekoppelt ist. Ein Meldegerät oder Sensor liefert Eingangssignale, die von dem Sicherheitsschaltgerät ausgewertet und ggf. miteinander verknüpft werden, um in Abhängigkeit davon Aktuatoren der Anlage, wie etwa einen elektrischen Antrieb oder ein Magnetventil, ein- oder abzuschalten. In vielen Fällen liefern die Meldegeräte recht einfache binäre Informationen, etwa ob eine mechanische Schutztür geschlossen ist oder nicht, ob ein Notaustaster betätigt ist oder nicht, ob eine Lichtschranke unterbrochen ist oder nicht. Darüber hinaus können Meldegeräte/Sensoren auch analoge Werte liefern, etwa die Temperatur eines Kessels oder die Drehzahl eines Antriebs. Üblicherweise gibt das Sicherheitsschaltgerät der Sicherheitsschaltungsanordnung den Betrieb der Anlage nur dann frei, wenn anhand der Signale von den Meldegeräten/Sensoren ein ungefährlicher Betrieb angenommen werden kann.

Die Anforderungen, die an eine Sicherheitsschaltungsanordnung im Sinne der vorliegenden Erfindung gestellt werden, sind in vielen Staaten reguliert und in nationalen wie internationalen Normen kategorisiert und festgeschrieben. In Europa sind die einschlägigen Normen und Richtlinien beispielsweise die Maschinenrichtlinie 2006/42/EG oder die zentrale Sicherheitsnorm für die Auslegung sicherheitsgerichteter Steuerungen für Maschinen EN ISO 13849-1 als Nachfolger der EN 954-1. Ein Sicherheitsschaltungsanordnung im Sinne der Erfindung ist dabei eigenfehlersicher im Sinne von SIL 2 der Internationalen Norm IEC 61508 und weist ein Performance Level von d oder höher im Sinne der EN ISO 13849-1 auf.

Bei großen Anlagen kann es eine Vielzahl von Meldegeräten/Sensoren geben, die räumlich verteilt sicherheitsrelevante Eingangssignale an ein oder mehrere Sicherheitsschaltgeräte liefern. Die Meldegeräte und Sensoren sind dabei an und um die Anlage herum, im sogenannten Feld, verteilt, während das oder die Sicherheitsschaltgeräte üblicherweise zentral in einem geschlossenen Schaltschrank untergebracht sind, über den regelmäßig auch die übrige Steuerung und die Versorgung der Anlage erfolgt. Die zentrale Auswertung und Steuerung ermöglicht eine einfache Bedienung und Wartung der Anlage, führt jedoch auch zu einem hohen Installations- und Verkabelungsaufwand, da alle sicherheitskritischen Eingangssignale sicher und zuverlässig von den Meldegeräten und Sensoren zu der zentralen Stelle geführt werden müssen. Bei größeren Anlagen rentiert sich diese Zentralisierung oftmals, da sich sicherheitstechnische Aspekte einzelner Komponenten, wie beispielsweise ein spritzwassergeschütztes Gehäuse, für eine Vielzahl von Geräten zusammenfassen lassen, beispielsweise indem die Komponenten in einem gemeinsamen geschlossenen und spritzwassergeschützten Schaltschrank untergebracht sind. Eine einzelne Komponente kann so geringeren Anforderungen genügen und damit kostengünstiger hergestellt werden.

Bei mittleren, kleinen oder sogar mobilen Anlagen lohnt sich eine derartige Zentralisierung hingegen oftmals nicht. Insbesondere bei Geräten mit nur einem oder zwei Meldegeräten, die jeweils von genau einem Sicherheitsschaltgerät überwacht werden, ist eine Verlagerung der Letztgenannten weg von der Anlage in einen separaten Schaltschrank nicht zweckmäßig. Ebenso unzweckmäßig ist eine derartige Zentralisierung bei Anlagen, die außerhalb des industriellen Umfelds im Endkundenbereich eingesetzt und sicherheitstechnisch überwacht werden müssen, bei denen jedoch Infrastrukturbedingungen, wie sie in einer industriellen Produktionsstätte vorherrschen, nicht gegeben sind. Beispiele für solch eine Anlage sind sehr kleine Maschinen und Anlagen, wie beispielsweise ein Brotschneideautomat, der im Verkaufsraum eines Diskounters aufgestellt ist und in erster Linie vom Endkunden selbst bedient wird.

Ist eine Zentralisierung der Sicherheitstechnik nicht zweckmäßig, werden Sicherheitsschaltanordnungen mit Melde- und Sicherheitsschaltgerät direkt an der Anlage angeordnet. Durch die Anordnung beider Komponenten der Sicherheitsschaltungsanordnung unmittelbar an der Anlage entfällt zwar die aufwändige Verkabelung im Feld, allerdings sind auch bei dieser Anordnung oftmals das Meldegerät und das Sicherheitsschaltgerät nicht als eine Einheit ausgebildet, sondern nach wie vor zwei einzelne Komponenten, die über ein Kabel, wenn auch nur ein kurzes, miteinander verbunden werden müssen. Die sicherheitstechnischen Anforderungen an die einzelnen Komponenten, und insbesondere an deren Verbindung untereinander, sind dabei dieselben, wie bei Systemen mit Sicherheitsschaltgeräten zentral in einem Schaltschrank, die mit Meldegeräten im Feld kommunizieren.

Prinzipiell wäre es daher möglich, bekannte Sicherheitssysteme aus dem industriellen Umfeld auch in Einzelsystemen einzusetzen. Allerdings sind diese Systeme oftmals für eine solche Anwendung nicht ausgelegt und bringen einen Überschuss an Funktionen mit, der die Kosten von Einzelsystemen unnötig erhöhen würde. Ebenso sind die Formfaktoren bei Sicherheitsschaltgeräten, die in einem Schaltschrank verwendet werden, andere als bei Sicherheitsschaltgeräten, die in einem Einzelsystem integriert werden sollen. Insbesondere ist es wünschenswert, dass eine Sicherheitsschaltungsanordnung für Einzelsysteme möglichst kompakt und kleinbauend ist, um einfach in bestehende Systeme integriert werden zu können.

Gleichzeitig sollen die Einzelsysteme jedoch ebenfalls die hohen Sicherheitsanforderungen der einschlägigen Normen erfüllen können, wie vergleichbare Systeme mit einer zentralen Auswertung und Steuerung aus dem industriellen Umfeld, zumal diese Systeme oft von Endanwendern und nicht von geschultem Personal bedient werden.

Die Dokumente EP 2 383 762 A1, DE 94 14 079 U1 und EP 2 983 187 A2 offenbaren jeweils eine Sicherheitsschaltungsanordnung gemäß dem Oberbegriff des Patentanspruchs 1.

EP 2 383 762 A1 offenbart ein System mit mindestens zwei Sicherheitsschaltvorrichtungen, die über eine einkanalige Verbindung fehlersicher zusammenwirken. Hierfür wird ein getaktetes Signal von der ersten Vorrichtung zu der zweiten Vorrichtung übertragen. Ferner ist das getaktete Signal dazu geeignet die zweite Sicherheitsschaltvorrichtung mit Energie zu versorgen.

DE 94 14 079 U1 offenbart eine Sicherheitsschaltungsanordnung mit wenigstens einem Not-Aus-Schalter, wobei die Sicherheitsschaltungsanordnung an eine Gleichspannungsquelle angeschlossen werden kann oder alternativ mit einer Wechselspannungsquelle versorgt werden kann, die zunächst gleichgerichtet wird.

EP 2 983 187 A2 offenbart ein Schütz bzw. einen Stecker und eine Schützkomponente. Eine Steuerschaltung umfasst eine PWM-Sparschaltung, die auf dem Stecker integriert sein kann, wodurch der durchschnittliche Treiberstrom des Schützes und gleichzeitig die Größe des Schützes reduziert werden kann.

Vor diesem Hintergrund ist es eine Aufgabe der vorliegenden Erfindung, eine Sicherheitsschaltungsanordnung anzugeben, die sich kostengünstig realisieren lässt und trotzdem eine fehlersichere Abschaltung ermöglicht, insbesondere wenn Meldegerät und Sicherheitsschaltgerät räumlich voneinander getrennt, aber dennoch nahe beieinander, angeordnet sind. Ebenso ist es eine Aufgabe, eine möglichst platzsparende und kompakte Sicherheitsschaltungsanordnung sowie ein entsprechendes Sicherheitsschaltgerät anzugeben.

Gemäß der Erfindung wird diese Aufgabe gelöst durch eine Sicherheitsschaltungsanordnung zum fehlersicheren Abschalten einer elektrisch angetriebenen Anlage mit einem Sicherheitsschaltgerät, das ein Sicherheitsschaltrelais mit einer definierten Ansteuerleistung aufweist und dazu ausgebildet ist, einen Stromversorgungspfad zu der Anlage fehlersicher zu schließen oder zu trennen, und mit einem Meldegerät, das einen Betätiger und einen Signalgenerator aufweist und über eine erste Leitung mit dem Sicherheitsschaltgerät verbunden ist, wobei der Betätiger zwischen einem ersten definierten Zustand und einem zweiten definierten Zustand wechselbar ist, und der Signalgenerator dazu ausgebildet ist, auf der ersten Leitung ein erstes Taktsignal nur dann zu erzeugen, wenn der Betätiger in dem ersten definierten Zustand ist, wobei das Sicherheitsschaltgerät dazu ausgebildet ist, dem ersten Taktsignal ausschließlich aus einem dynamischen Anteil elektrische Leistung größer oder gleich der Ansteuerleistung des Sicherheitsschaltrelais zu entnehmen und in Gleichstrom zum Ansteuern des Sicherheitsschaltrelais umzusetzen.

Bei der neuen Sicherheitsschaltungsanordnung ist es somit eine Idee, die Energie, die zum Schalten des Strompfads durch das Sicherheitsschaltgerät benötigt wird, dem Meldesignal des Meldegeräts zu entnehmen. Das Signal wird dabei unabhängig vom Sicherheitsschaltgerät durch das Meldegerät erzeugt und an das Sicherheitsschaltgerät übertragen. Unabhängig heißt in diesem Zusammenhang, dass das neue Meldegerät eine eigene Energiequelle aufweist, oder mit einer solchen unmittelbar verbunden ist, und je nach Zustand des Betätigers ein Taktsignal mit einer definierten Leistung aus dieser Energiequelle generiert und an einem Ausgang bereitstellt.

Das Taktsignal ist eine Wechselgröße mit einer Wechselspannung, die einen definierten Effektivwert aufweist. Das Sicherheitsschaltgerät setzt diese Wechselspannung in einen Gleichstrom mit einer definierten Leistung um. Entspricht die umgesetzte Leistung mindestens der Ansteuerleistung des Sicherheitsschaltrelais, wird dieses eingeschaltet und ein Stromversorgungspfad zur technischen Anlage geschlossen. Liegt zwischen den Leitungen hingegen eine Gleichspannung, eine Wechselspannung mit einem geringeren Effektivwert oder gar kein Signal an, so schaltet das Sicherheitsschaltrelais ab bzw. erst gar nicht an. Die Information über den Zustand des Meldegeräts wird somit in der Wechselspannungsleistung des Meldesignals kodiert, wobei die Leistung gleichzeitig zum Betrieb des Sicherheitsschaltgeräts, insbesondere des Sicherheitsschaltrelais, herangezogen wird.

Im Gegensatz zu bekannten Sicherheitsschaltungsanordnungen fungiert somit nicht das Sicherheitsschaltgerät als Energiequelle, sondern das Meldegerät. Das hat den Vorteil, dass das Sicherheitsschaltgerät auf ein Minimum an für das Schalten des Strompfads notwendigen Komponenten reduziert werden kann. Das Sicherheitsschaltgerät lässt sich somit besonders einfach, kompakt und kostengünstig aufbauen. In einigen Ausführungsbeispielen umfasst das Sicherheitsschaltgerät ausschließlich ein Sicherheitsschaltrelais sowie elektrische Bauteile, die die Wechselspannung des Tastsignals in Gleichstrom umsetzen und über die Erregerspule des Sicherheitsschaltrelais führen.

Trotz einer minimalen Ausgestaltung des Sicherheitsschaltgeräts kann die beanspruchte Sicherheitsschaltungsanordnung die Anforderung einer hohen Sicherheitskategorie der eingangs genannten Normen erfüllen. Dies liegt u.a. daran, dass das Meldegerät das Meldesignal selbst erzeugt und somit auf eine übliche Signalschleife vom Steuergerät zum Meldegerät und zurück verzichtet werden kann. Ein Überbrücken des Meldegeräts durch einen Querschluss zwischen der Hinleitung und der Rückleitung einer solchen Signalschleife kann somit vermieden werden. Ebenso führt ein Kurzschluss zu einem Masseanschluss oder zu einem Versorgungspotential dazu, dass das Sicherheitsschaltrelais abschaltet, da zum Einschalten und Halten des Sicherheitsschaltrelais lediglich die Wechselspannungsleistung berücksichtigt wird. Potentielle Fehlerquellen bekannter Sicherheitsschaltungsanordnungen können so effektiv vermieden werden.

Insgesamt beschreibt die neue Sicherheitsschaltungsanordnung somit ein System, das auf ein Minimum an notwendigen Komponenten reduziert worden ist und gleichzeitig hohe Sicherheitsanforderungen erfüllt. Insbesondere wenn ausschließlich ein Meldegerät mit einem Sicherheitsschaltgerät verknüpft werden soll, bietet die neue Sicherheitsschaltungsanordnung eine einfache und kostengünstige Alternative zu bekannten Sicherheitsschaltungsanordnungen. Die oben genannte Aufgabe ist damit vollständig gelöst.

In einer weiteren Ausgestaltung ist das Sicherheitsschaltgerät dazu ausgebildet, ausschließlich die dem ersten Taktsignal entnommene Leistung zum Anziehen des Sicherheitsschaltrelais zu verwenden. Indem das Sicherheitsschaltgerät als ausschließliche Energiequelle das Taktsignal des Meldegeräts heranzieht, kann das Sicherheitsschaltgerät besonders einfach aufgebaut sein. Insbesondere kann auf zusätzliche Anschlüsse zum Aufnehmen einer Betriebsspannung sowie entsprechende elektrische Bauteile vollständig verzichtet werden. Gleichzeitig kann vermieden werden, dass durch einen Kurzschluss zwischen der Betriebsspannung und dem Ansteuerkreis des Sicherheitsschaltrelais dieses fälschlicherweise eingeschaltet wird, obwohl das Meldegerät einen anderen Zustand signalisiert. Das Weglassen einer eigenen Spannungsversorgung trägt damit vorteilhaft dazu bei, dass eine weitere potentielle Gefahrenquelle ausgeschlossen werden kann.

In einer weiteren Ausgestaltung ist das Meldegerät über eine zusätzliche zweite Leitung mit dem Sicherheitsschaltrelais verbunden und das Meldegerät weist einen ersten und einen zweiten Anschluss zum Aufnehmen einer Versorgungsspannung sowie einen dritten Anschluss zum Bereitstellen des Taktsignals auf, wobei der erste Anschluss mit der zweiten Leitung verbunden ist und der dritte Anschluss mit der ersten Leitung verbunden ist, um dem Sicherheitsschaltgerät ein gemeinsames Potential, insbesondere ein gemeinsames Massepotential, sowie das erste Taktsignal bereitzustellen. In dieser Ausgestaltung ist das Meldegerät somit mit einer Versorgungsspannung als Energiequelle gekoppelt, insbesondere mit einer in der Automatisierungstechnik gewöhnlichen 24 Volt Gleichspannung. Ein Pol der Gleichspannung, insbesondere ein Massepotential, wird zusammen mit dem Taktsignal an das Sicherheitsschaltgerät weitergeleitet. Indem zusätzlich zu dem Taktsignal ein gemeinsames Massepotential bereitgestellt wird, benötigt das Sicherheitsschaltgerät nur Anschlüsse für die erste und zweite Leitung. Es werden keine weiteren Anschlüsse benötigt. Dies trägt zu einem vereinfachten und kompakten Aufbau der Sicherheitsschaltungsanordnung bei.

In einer weiteren Ausgestaltung ist der Signalgenerator eingangsseitig zwischen dem ersten Anschluss und dem zweiten Anschluss angeordnet und ausgangsseitig mit dem dritten Anschluss verbunden. Diese Ausgestaltung trägt zu einem besonders einfachen Aufbau des Meldegeräts bei. Insbesondere wenn der Signalgenerator als einfache, vorzugweise integrierte Schaltung ausgebildet ist, kann dieser auf einfache Weise in bestehende Meldegeräte integriert werden, um die neue Funktion bereitzustellen.

In einer weiteren Ausgestaltung weist der Betätiger einen ersten und einen zweiten Öffnerkontakt auf, wobei der erste Öffnerkontakt zwischen dem ersten Anschluss und dem Signalgenerator und der zweite Öffnerkontakt zwischen dem Signalgenerator und dem dritten Anschluss angeordnet ist. Durch diese Ausgestaltung kann eine weitere potentielle Fehlerquelle im Meldegerät vermieden werden. Indem über einen Öffnerkontakt die Versorgungsspannung zum Signalgenerator geführt wird und über einen zweiten Öffnerkontakt das generierte Taktsignal an den Ausgang des Meldegeräts geführt wird, können Fehler im Kontaktsatz des Betätigers ausgeschlossen werden, da ein Querschluss im Schaltersatz des Betätigers in jedem Fall zu einer Unterbrechung des Taktsignals am Ausgang führen würde. Lediglich eine Teilbetätigung müsste zusätzlich überwacht werden.

In einer weiteren Ausgestaltung ist der Signalgenerator ein Oszillator, insbesondere ein Sinus-Oszillator. Ein Oszillator lässt sich besonders einfach und kostengünstig realisieren. Vorzugsweise erzeugt der Oszillator eine Sinus-Wechselspannung ohne Gleichstromanteile. Dieser eignet sich für eine besonders effiziente Ausgestaltung der Sicherheitsschaltungsanordnung.

In einer weiteren Ausgestaltung weist das Sicherheitsschaltgerät zum Entnehmen und Umsetzen der elektrischen Leistung einen Trafo und einen Gleichrichter auf, wobei der Trafo primärseitig mit der ersten und zweiten Leitung verbunden ist und sekundärseitig mit dem Gleichrichter, sodass nur Wechselstromanteile des ersten Taktsignals in elektrische Leistung umgesetzt werden. Diese Ausgestaltung trägt weiter zu einer kostengünstigen Realisierung der Sicherheitsschaltungsanordnung bei, da neben dem Trafo, Gleichrichter und Sicherheitsschaltrelais keine weiteren elektrischen Komponenten benötigt werden, um ein fehlersicheres Abschalten einer technischen Anlage zu gewährleisten. Da ein Transformator lediglich Wechselstromanteile übertragen kann, haben etwaige Gleichstromanteile oder konstante Spannungen, die an den Eingängen des Sicherheitsschaltgeräts anliegen, keinen Einfluss auf das Sicherheitsschaltrelais.

In einer weiteren Ausgestaltung sind die erste und eine zweite Leitung je eine Ader einer Zweidrahtleitung. In dieser Ausgestaltung sind das Meldegerät und das Sicherheitsschaltgerät über eine einfache Zweidrahtleitung verbunden, wodurch die Sicherheitsschaltungsanordnung besonders kostengünstig realisiert werden kann. Durch die erfindungsgemäße Ausgestaltung ist eine Zweidrahtleitung zwischen den beiden Komponenten der Sicherheitsschaltungsanordnung ausreichend, um ein sicheres Abschalten einer technischen Anlage durch die Sicherheitsschaltungsanordnung zu gewährleisten.

In einer weiteren Ausgestaltung weist das Sicherheitsschaltrelais eine zur Ansteuerleistung geringere Halteleistung auf, und der Signalgenerator ist dazu ausgebildet, ein zweites Taktsignal bereitzustellen, wobei das Sicherheitsschaltgerät dazu ausgebildet ist, dem zweiten Taktsignal eine elektrische Leistung größer oder gleich der Halteleistung des Sicherheitsschaltrelais, jedoch kleiner der Ansteuerleistung zu entnehmen und in Gleichstrom zum Halten des Sicherheitsschaltrelais umzusetzen. In dieser Ausgestaltung wird berücksichtigt, dass ein Relais üblicherweise eine höhere Leistung zum Ansteuern als zum Halten des Relaisankers benötigt. So kann die Sicherheitsschaltungsanordnung besonders energieeffizient ausgestaltet werden.

Vorzugsweise ist der Signalgenerator dazu ausgebildet, beim Wechsel des Betätigers vom zweiten in den ersten Zustand das erste Taktsignal für eine definierte Zeitspanne, insbesondere für 20 bis 200 ms, bereitzustellen und anschließend das zweite Taktsignal, solange der Betätiger im ersten Zustand ist. Indem der Signalgenerator nur zum Ansteuern des Relais ein Taktsignal mit höherer Leistung bereitstellt und im Dauerbetrieb ein zweites Taktsignal mit geringerer Leistung, kann die neue Sicherheitsschaltungsanordnung besonders energieeffizient umgesetzt werden. Zudem kann zuverlässig vermieden werden, dass nach einer Abschaltung das Sicherheitsschaltrelais unbeabsichtigt wieder anzieht, da nur das zweite Taktsignal zur Verfügung steht und dieses nicht über die notwendige Leistung verfügt, das Sicherheitsschaltrelais einzuschalten.

In einer weiteren Ausgestaltung ist das Sicherheitsschaltgerät dazu ausgebildet, nach dem Ansteuern des Sicherheitsschaltrelais eine Energiesenkung des ersten Taktsignals vorzunehmen, sodass das Sicherheitsschaltgerät dem ersten Taktsignal eine elektrische Leistung größer oder gleich der Halteleistung des Sicherheitsschaltgeräts, jedoch kleiner der Ansteuerleistung entnehmen und in Gleichstrom zum Halten des Sicherheitsschaltrelais umsetzen kann. In dieser Ausgestaltung ist somit das Sicherheitsschaltgerät dazu ausgebildet, nach dem Einschalten die Leistung des Taktsignals zu verringern, beispielsweise indem ein Widerstand in einem Selbsthaltungskreis des Sicherheitsschaltrelais angeordnet ist. Der Widerstand senkt die Leistung, die am Relais zur Verfügung steht und damit auch die Verlustleistung, die vom Relais in Wärme umgewandelt wird.

In einer weiteren Ausgestaltung ist das Relais ein Doppelankerrelais mit zwei getrennten Kontaktsätzen, jedoch nur mit einer Spule. Diese Ausgestaltung trägt zu einer weiteren Reduzierung der Kosten der Sicherheitsschaltungsanordnung bei. Durch die Verwendung eines Doppelankerrelais mit zwei getrennten Kontaktsätzen kann ein redundantes Abschalten bereits mit einem einzigen Sicherheitsschaltrelais gewährleistet werden. Eine derartige Ausgestaltung ist günstiger als die Verwendung von zwei parallel geschalteten Sicherheitsschaltrelais, um die nötige Redundanz zu gewährleisten.

Ausführungsbeispiele der Erfindung sind in der Zeichnung dargestellt und werden in der nachfolgenden Beschreibung näher erläutert. Es zeigen:
- Fig. 1: ein bevorzugtes Anwendungsgebiet der neuen Sicherheitsschaltungsanordnung,
- Fig. 2: eine schematische Darstellung eines ersten Ausführungsbeispiels der neuen Sicherheitsschaltungsanordnung,
- Fig. 3: ein bevorzugtes Ausführungsbeispiel eines neuen Meldegeräts, und
- Fig. 4: ein bevorzugtes Ausführungsbeispiel eines neuen Sicherheitsschaltgeräts.

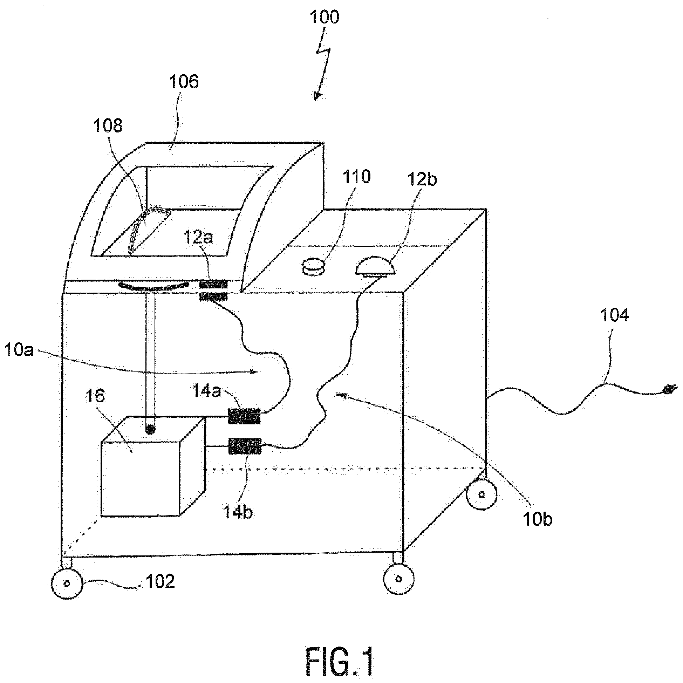

Fig. 1 illustriert ein bevorzugtes Anwendungsgebiet der neuen Sicherheitsschaltungsanordnung. Mit der Bezugsziffer 100 ist hier ein Brotschneideautomat angedeutet, wie er beispielsweise in einem Verkaufsraum eines Diskounters aufgestellt sein kann. Der Brotschneideautomat ist in diesem Beispiel auf Rollen 102 angeordnet und somit im Raum beweglich. Über einen Stecker 104 wird der Automat an einen gewöhnlichen Stromanschluss, beispielsweise einen 220-Volt-Hausanschluss, angeschlossen und mit Energie versorgt. Darüber hinaus weist der Brotschneideautomat 100 ein erstes und ein zweites Ausführungsbeispiel der neuen Sicherheitsschaltungsanordnung 10 jeweils mit einem Meldegerät 12a, 12b und einem Sicherheitsschaltgerät 14a, 14b auf.

Hinter einer Abdeckung 106 befindet sich bei dem Automaten eine Schneidvorrichtung 108, die über einen Antrieb 16 angetrieben wird. Um einen Schneidvorgang einzuleiten, öffnet ein Anwender die Abdeckung 106, legt ein Brot ein und betätigt nach dem Schließen der Abdeckung 106 den Startknopf 110. Nach dem Schneidvorgang öffnet der Anwender die Abdeckung 106 und entnimmt das geschnittene Brot. Es versteht sich, dass während des Schneidvorgangs von der Schneidvorrichtung 108 eine Gefahr für den Anwender ausgeht, sollte dieser im Betrieb in die Schneidvorrichtung 108 greifen.

Zum Schutz des Anwenders erfolgt der Schneidvorgang daher nur bei geschlossener Abdeckung 106. Eine erste Sicherheitsschaltungsanordnung 10a überwacht dabei, ob die Abdeckung 106 verschlossen ist. Hierzu ist ein Meldegerät 12a im Sinne der Erfindung hier als Kontaktschalter oder Magnetschalter ausgebildet und mit der Abdeckung 106 gekoppelt. Das Meldegerät 12a signalisiert dem Sicherheitsschaltgerät 14a einen ersten Zustand, wenn die Abdeckung 106 geschlossen ist, und einen zweiten Zustand, wenn die Abdeckung geöffnet ist oder wird. Nur wenn die Abdeckung 106 geschlossen ist und das Sicherheitsschaltgerät 14a das entsprechende Signal des Meldegeräts 12a erhält, erlaubt das Sicherheitsschaltgerät 14a das Anlaufen des Antriebs 16. Liegt das entsprechende Signal nicht an, schaltet das Sicherheitsschaltgerät 14a den Antrieb ab bzw. diesen erst gar nicht an.

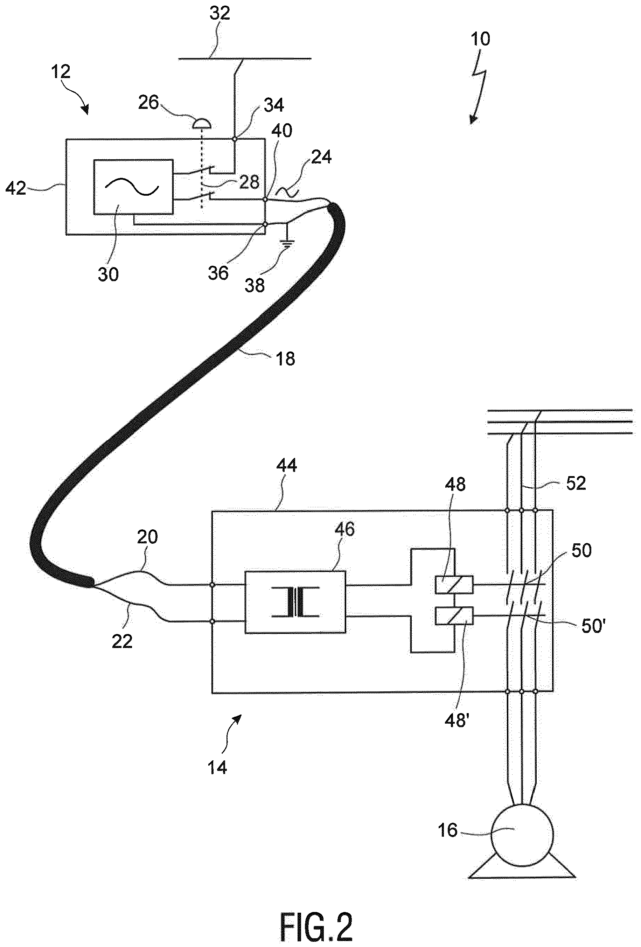

Das zweite Ausführungsbeispiel der neuen Erfindung umfasst einen Notausschalter 12b, der am Automaten 100 angeordnet ist und über den ein Anwender den Schneidvorgang manuell unterbrechen kann. Das fehlersichere Abschalten des Antriebs 16 erfolgt hierbei auf die gleiche Weise jedoch über das Sicherheitsschaltgerät 14b. Das Zusammenwirken der Meldegeräte 12a, 12b mit den Sicherheitsschaltgeräten 14a, 14b im Sinne der vorliegenden Erfindung wird im Folgenden mit Bezug auf die Fig. 2 näher erläutert

Es versteht sich, dass der hier gezeigte Automat nur ein Beispiel von vielen ist, in denen die neue Sicherheitsschaltungsanordnung Anwendung finden kann. Vorzugsweise wird die neue Sicherheitsschaltungsanordnung in Einzelsystemen eingesetzt, die im Betrieb eine Gefahr für den Anwender darstellen und entsprechend mit ein oder zwei Sicherheitskomponenten abzusichern sind. Bei den bevorzugten Automaten handelt es sich somit um mittlere oder kleine, insbesondere mobile Anlagen, die außerhalb des industriellen Umfelds im Endkundenbereich eingesetzt werden. Die Anforderungen an die Absicherung solcher Einzelsysteme sind jedoch dieselben, wie bei Anlagen im industriellen Umfeld, bspw. einer CNC-Fräse.

Mit Bezug auf die Fig. 2 wird ein Ausführungsbeispiel der neuen Sicherheitsschaltungsanordnung im Detail erläutert. Die neue Sicherheitsschaltungsanordnung ist in ihrer Gesamtheit hier mit der Bezugsziffer 10 bezeichnet. Die Sicherheitsschaltungsanordnung 10 beinhaltet ein Meldegerät 12 und ein Sicherheitsschaltgerät 14. Die beiden Komponenten wirken so zusammen, dass eine technische Anlage, die hier durch einen Motor 16 angedeutet ist, fehlersicher abgeschaltet werden kann. Das Meldegerät 12 und das Sicherheitsschaltgerät 14 sind in diesem Ausführungsbeispiel über eine Zweidrahtleitung 18 mit einer ersten Ader 20 und einer zweiten Ader 22 verbunden. Die erste und zweite Ader 20, 22 sind somit eine erste und eine zweite Leitung im Sinne der vorliegenden Erfindung.

Es versteht sich, dass eine Zweidrahtleitung, wie hier gezeigt, nur eine Möglichkeit darstellt, das Meldegerät 12 und das Sicherheitsschaltgerät 14 miteinander zu verbinden. Eine Zweidrahtleitung hat jedoch den Vorteil, dass diese besonders günstig ausgelegt sein kann. In bevorzugten Ausführungsbeispielen handelt es sich bei der Zweidrahtleitung 18 um eine sehr kurze Leitung innerhalb der zu überwachenden Maschine.

Das Meldegerät 12 ist dazu ausgebildet, ein erstes Taktsignal 24 als Meldesignal an das Sicherheitsschaltgerät 14 zu übermitteln. Das Meldegerät 12 besitzt einen Betätiger 26, der hier ein handbetätigter Taster ist. Der Betätiger 26 ist über eine Feder (hier nicht dargestellt) in einer ersten Betriebsposition vorgespannt, in der hier ein elektrischer Kontakt 28 geöffnet ist. Dies ist im vorliegenden Ausführungsbeispiel der inaktive Ruhezustand (zweiter Zustand) des Betätigers 26. Der Betätiger 26 kann gegen die Federkraft in eine zweite Betriebsposition gebracht werden, in der die Arbeitskontakte 28 geschlossen sind. Bei geschlossenen Arbeitskontakten 28 ist ein Signalgenerator 30 mit einer Betriebsspannung 32 verbunden. Der Signalgenerator 30 erzeugt dann das Taktsignal 24, welches hier als ein sinusförmiges Signal dargestellt ist. Dieser Zustand ist somit ein definierter erster Zustand im Sinne der vorliegenden Erfindung. In dem hier dargestellten Ausführungsbeispiel erhält der Signalgenerator 30 die für das Erzeugen des Taktsignals benötigte Betriebsspannung nur bei aktivem Betätiger 26. Andernfalls ist er spannungslos. Der Signalgenerator 30 erzeugt somit das Taktsignal 24 nur dann, wenn sich der Betätiger 26 in dem definierten ersten Zustand befindet. Im dargestellten Ausführungsbeispiel ist der Betätiger ein einfacher handbetätigter Schalter mit einem oder mehreren Arbeitskontakten 28. In anderen Ausführungsbeispielen kann der Betätiger insbesondere einen Öffnerkontakt oder eine Kombination von Öffner- und Schließerkontakten aufweisen. Des Weiteren kann der Betätiger ein Transponder, eine Lichtschranke oder ein Messwertgeber für Temperatur, Druck, Spannung sein.

Das Meldegerät 12 bildet in Bezug auf das Sicherheitsschaltgerät 14 eine eigene Einheit, ist jedoch vorzugsweise in der Nähe des Sicherheitsschaltgeräts 14 und des Antriebs 16 angeordnet, sodass die Verbindung zwischen dem Meldegerät 12 und dem Sicherheitsschaltgerät 14 über eine kurze Leitung, vorzugweise innerhalb der Maschine, möglich ist. Das Meldegerät 12 kann in anderen Ausführungsbeispielen als Notaustaster, Schutztürschalter, Näherungsschalter, Lichtschranke, Temperaturwächter oder dergleichen ausgebildet sein.

Neben den Arbeitskontakten 28 ist der Signalgenerator 30 das zentrale Element des Meldegeräts 12. Der Signalgenerator 30 ist in einem bevorzugten Ausführungsbeispiel ein Oszillator, der dazu ausgebildet ist, eine sinusförmige Wechselspannung beispielsweise mit 10kHz zu erzeugen. Ein Signalgenerator 30, der eine sinusförmige Wechselspannung erzeugt, kann beispielsweise ein einfacher Wien-Robinson-Oszillator sein. Der Oszillator ist hier mit einem ersten und einem zweiten Anschluss 34, 36 mit einer Betriebspotential 32 und einem Masseanschluss 38 verbunden, so dass zwischen dem ersten und dem zweiten Anschluss eine Betriebsspannung abfällt. Über einen dritten Anschluss 40 stellt der Signalgenerator 30 das Taktsignal 24 bereit. Der erste, zweite und dritte Anschluss 34, 36, 40 sind vorzugsweise als Anschlussklemmen an einem Gehäuse 42 des Meldegeräts 12 realisiert.

Das erste Taktsignal 24 ist in diesem Ausführungsbeispiel eine sinusförmige Wechselspannung. In anderen Ausführungsbeispielen kann das Taktsignal aber auch eine andere Wechselgröße, wie beispielsweise ein definiertes Pulssignal mit einer Vielzahl von einzelnen Pulsen sein. Von Bedeutung für die erfindungsgemäße Funktion der Sicherheitsschaltungsanordnung ist jedoch, dass das Taktsignal 24 dazu ausgebildet ist, eine definierte Leistung vom Meldegerät 12 zum Sicherheitsschaltgerät 14 zu übertragen, wie im Folgenden noch näher in Bezug auf das Sicherheitsschaltgerät 14 erläutert wird.

Das Sicherheitsschaltgerät 14 ist über die beiden Leitungen 20, 22 mit dem Meldegerät 12 verbunden. Die Leitung 20 ist mit dem dritten Anschluss des Meldegeräts verbunden und die Leitung 22 mit dem zweiten Anschluss des Meldegeräts. Mit anderen Worten wird über die Leitung 20 das Taktsignal 24 vom Meldegerät 12 zum Sicherheitsschaltgerät 14 übertragen, während über die Leitung 22 ein gemeinsamer Masseanschluss 38 für das Meldegerät 12 und das Sicherheitsschaltgerät 14 bereitgestellt wird. Die Verbindung der ersten und zweiten Leitungen 20, 22 erfolgt wie beim Meldegerät 12 über Anschlussklemmen an einem Gehäuse 44 des Sicherheitsschaltgeräts 14.

Das Sicherheitsschaltgerät 14 überwacht den Betriebszustand des Meldegeräts 12 und beinhaltet eine Schaltungsanordnung sowie mindestens ein Sicherheitsschaltrelais 48. Die Schaltungsanordnung ist als ein Umsetzer 46 ausgebildet, der eingangsseitig mit den Anschlüssen zum Aufnehmen des Taktsignals und des Masseanschlusses verbunden ist und ausgangsseitig eine Gleichspannung zum Ansteuern des Sicherheitsschaltrelais 48 bereitstellt.

Der Umsetzer 46 ist vorzugsweise aus diskreten elektrischen Bauelementen aufgebaut und dazu ausgebildet, dem ersten Taktsignal 24 elektrische Energie zu entnehmen und in Gleichstrom mit einer definierten Leistung umzusetzen. Insbesondere ist der Umsetzer 46 dazu ausgebildet, aus einem Wechselanteil des Taktsignals 24 elektrische Energie zu entnehmen, während gleichförmige Anteile von dem Umsetzer 46 unberücksichtigt bleiben. Liegt folglich an den Eingängen des Sicherheitsschaltgeräts 14 kein Signal, ein konstantes Signal oder aber ein Wechselsignal mit einem geringen Effektivwert an, so ist eine Leistung des Gleichstroms, der durch den Umsetzer 46 bereitgestellt wird, nicht ausreichend, um das Sicherheitsschaltrelais 48 anzusteuern.

Das Sicherheitsschaltrelais 48 weist ein oder mehrere Arbeitskontakte 50 auf, die in einem Stromversorgungspfad 52 zu der technischen Anlage 16 angeordnet sind. Wenn durch de Umsetzer 46 zum Ansteuern des Sicherheitsschaltrelais 48 ein Gleichstrom mit ausreichender Leistung bereitgestellt wird, werden die Arbeitskontakte 50 des Sicherheitsschaltrelais 48 geschlossen und die technische Anlage 16 mit einer Spannungsversorgung verbunden. Es versteht sich, dass in anderen Ausführungsbeispielen auch andere Aktoren, wie etwa ein Schütz oder ein Magnetventil, angesteuert werden können. Darüber hinaus kann das Sicherheitsschaltgerät 14 ein weiteres parallel zum ersten Relais 48 geschaltetes Sicherheitsschaltrelais 48', dessen Arbeitskontakte 50' in Serie zu den Arbeitskontakten 50 des Sicherheitsschaltrelais 48 liegen, aufweisen.

Charakteristisch an der neuen Sicherheitsschaltungsanordnung 10 ist die Fähigkeit, neben einem Meldesignal auch Energie von einem Meldegerät 12 zu einem Sicherheitsschaltgerät 14 zu übertragen, sodass dieses vorzugsweise ohne eigene Spannungsversorgung auskommen kann. Das Meldegerät 12 zeichnet sich daher dadurch aus, dass es zum einen ein "eigenes" Taktsignal erzeugt und hierzu mit einer entsprechenden Spannungsquelle verbunden ist. Andererseits ist das Taktsignal 24 so ausgebildet, dass es nicht nur Informationen über den gegenwärtigen Zustand des Meldegeräts 12 umfasst, sondern auch elektrische Leistung überträgt, die vom Sicherheitsschaltgerät 14 verwendet wird, um ein Sicherheitsschaltrelais 48 anzusteuern.

Da im Gegensatz zu bekannten Sicherheitsschaltungsanordnungen das Meldegerät 12 kein Freigabe- oder Anforderungssignal von dem Sicherheitsschaltgerät 14 empfängt, kann eine Verbindung zwischen dem Meldegerät 12 und dem Sicherheitsschaltgerät 14 vorzugsweise über eine einfache Zweidrahtverbindung erfolgen, wobei sämtliche Fehler, die im Zusammenhang mit der Verbindung, wie beispielsweise Querschlüsse zwischen den Adern der Zweidrahtleitung, durch das Sicherheitsschaltgerät 14 beherrscht werden können. Darüber hinaus können durch geeignete Verschaltung des Signalgenerators und den Arbeitskontakten 28 des Betätigers 26 potentielle Fehlerquellen innerhalb des Meldegeräts 12 ausgeschlossen werden, da letzteres das Meldesignal selbst erzeugt. Charakteristisch an der neuen Sicherheitsschaltungsanordnung ist somit auch, dass das Sicherheitsschaltgerät 14 mit einer auf ein Minimum reduzierten Anzahl von, vorzugsweise diskreten, elektrischen Bauteilen auskommen kann und dennoch den Bedingungen einer hohe Sicherheitskategorie genügt.

Die neue Sicherheitsschaltungsanordnung 10 zeichnet sich somit dadurch aus, dass auf kostengünstige Art und Weise eine Kombination aus einem Meldegerät 12 und einem Sicherheitsschaltgerät 14 realisiert werden kann, die sich einfach in bestehende Systeme integrieren lässt, bei denen eine aus dem industriellen Umfeld bekannte Sicherheitsinfrastruktur nicht gegeben ist. Vielmehr kann die neue Sicherheitsschaltungsanordnung vorzugsweise autark und kostengünstig innerhalb eines Einzelsystems realisiert werden. Darüber hinaus ermöglicht der einfache Aufbau eine sehr kompakte Ausgestaltung insbesondere des Sicherheitsschaltgeräts 14. Dies ermöglicht neue Formfaktoren für Sicherheitsschaltgeräte 14 und eröffnet so neue Anwendungsmöglichkeiten für industrielle Sicherheitstechnik in normalen Benutzerendgeräten.

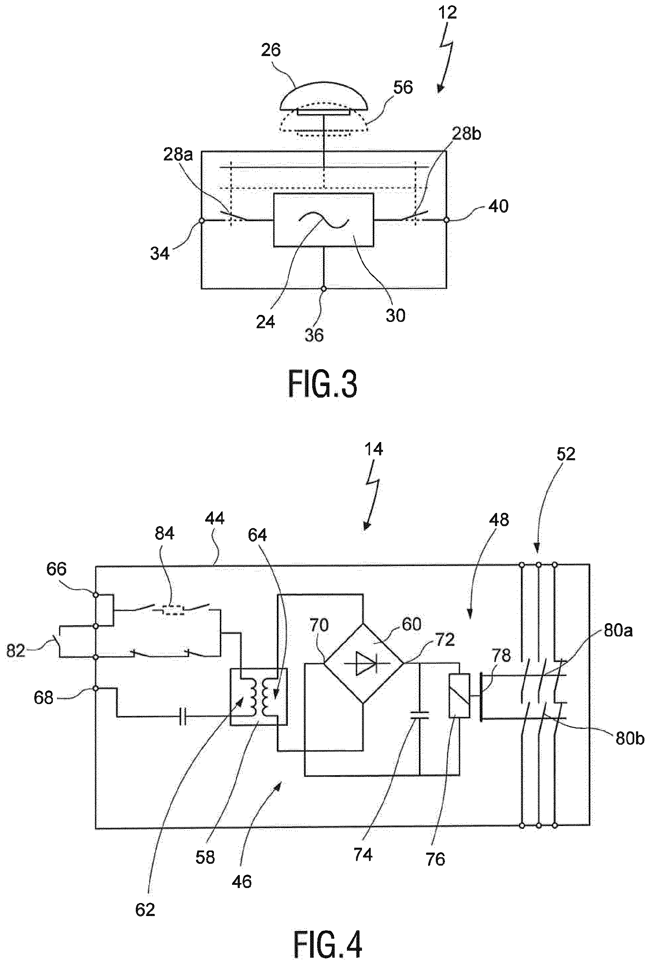

Mit Bezug auf die Fig. 3 und 4 werden im Folgenden ein bevorzugtes Ausführungsbeispiel eines neuen Meldegeräts 12 und ein bevorzugtes Ausführungsbeispiel eines neuen Sicherheitsschaltgeräts 14 näher erläutert.

Fig. 3 zeigt ein bevorzugtes Ausführungsbeispiel eines neuen Meldegeräts 12. Das Meldegerät 12 besitzt einen Betätiger 26 und einen Signalgenerator 30. Der Signalgenerator 30 und die Arbeitskontakte 28 des Betätigers sind in einem Gehäuse 42 angeordnet, an dessen Außenseite in diesem Ausführungsbeispiel drei Anschlussklemmen angeordnet sind, über die der Signalgenerator 30 im Gehäuse 42 kontaktierbar ist. Ein erster Anschluss 34 wird mit einem Betriebspotential, beispielsweise 24-Volt-Gleichstrom, verbunden und der zweite Anschluss 36 mit einem Masseanschluss. Über einen dritten Anschluss 40 wird das erste Taktsignal 24, welches das Meldegerät 12 generieren kann, nach außen geführt. Vorzugsweise weist das Meldegerät 12 keine weiteren Anschlüsse auf.

Der Betätiger 26 ist hier wie zuvor ein handbetätigter Taster, der eine erste Betriebsposition und eine zweite Betriebsposition (hier gestrichelt angedeutet) einnehmen kann. Der Betätiger 26 weist in diesem Ausführungsbeispiel einen ersten Arbeitskontakt 28a und einen zweiten Arbeitskontakt 28b auf. Die Arbeitskontakte 28a, 28b sind so eingerichtet, dass sie nur gemeinsam durch den Betätiger 26 verstellt werden können. Der erste Arbeitskontakt 28a ist zwischen dem ersten Anschluss und dem Signalgenerator 30 angeordnet und der zweite Arbeitskontakt 28b ist zwischen dem Signalgenerator 30 und dem dritten Anschluss 40 angeordnet. Mit anderen Worten kann der Betätiger 26 einerseits über den Arbeitskontakt 28a den Signalgenerator 30 von dem Betriebspotential, welches am ersten Anschluss 34 anliegt, trennen und andererseits die Ausgabe des vom Signalgenerator 30 generierten Taktsignals am dritten Anschluss 40 verhindern. In allen bevorzugten Ausführungsbeispielen ist das Meldegerät 12 daher so eingerichtet, dass ein Taktsignal 24 am dritten Anschluss 40 nur dann generiert wird, wenn der Betätiger in der zweiten Betriebsposition 56 ist.

In einem weiteren Ausführungsbeispiel kann das Meldegerät 12 optional zwischen den Arbeitskontakten 28 und dem Signalgenerator 30 eine Safety-State-Komponente aufweisen, die dazu ausgebildet ist, den Signalgenerator 30 so zu beeinflussen, dass dieser ein Signal nur dann ausgesendet, wenn beide Arbeitskontakte 28 vor einem Neustart als ausgeschaltet vorgefunden worden sind. Hier durch lässt sich die Sicherheit der Vorrichtung vorteilhaft weiter erhöhen.

Das Taktsignal 24, welches von dem Signalgenerator 30 bei Anliegen einer Betriebsspannung an den Anschlüssen 34, 36 automatisch erzeugt wird, ist vorzugsweise eine sinusförmige Wechselspannung ohne Gleichstromanteile. Charakteristisch für das Meldegerät 12 ist somit einerseits, dass das Meldegerät 12 das Taktsignal 24 selbst unabhängig vom zugehörigen Sicherheitsschaltgerät erzeugt und dass das Taktsignal 24 eine Wechselgröße beinhaltet, der sich eine bestimmte elektrische Energiemenge entnehmen lässt. Es versteht sich, dass in anderen Ausführungsbeispielen das Taktsignal 24 auch Gleichstromanteile aufweisen kann, wobei die zum Schalten benötigte Energie jedoch ausschließlich aus dem dynamischen Teil des Signals entnommen wird. Kennzeichnend für das Meldegerät 12 ist somit ein definierter Effektivwert des vom Signalgenerator 30 erzeugten Taktsignals 24.

Fig. 4 zeigt ein bevorzugtes Ausführungsbeispiel eines neuen Sicherheitsschaltgeräts. Das Sicherheitsschaltgerät weist hier ebenfalls ein Gehäuse 44 auf, welches die elektrischen Komponenten des Sicherheitsschaltgeräts 14 beherbergt. An dem Gehäuse 44 sind Anschlussklemmen angeordnet, über die das Sicherheitsschaltgerät 14 elektrisch kontaktierbar ist.

Wesentlicher Bestandteil des Sicherheitsschaltgeräts 14 sind ein Umsetzer 46 und ein Sicherheitsschaltrelais 48. Der Umsetzer 46 umfasst in diesem bevorzugten Ausführungsbeispiel ausschließlich einen Transformator 58 und einen Gleichrichter 60. Der Transformator 58 wandelt eine an der Primärseite 62 anliegende Wechselspannung in eine Ausgangswechselspannung um, die an der Sekundärseite 64 abgegriffen werden kann. Eine Transformation der Wechselspannung von Primärseite zur Sekundärseite hin erfolgt vorzugsweise nicht, d.h. ein Übertragungsfaktor des Umsetzers 46 ist gleich 1. Der Transformator 58 dient somit ausschließlich dazu, dass nur ein Wechselstromanteil von der Primärseite 62 auf die Sekundärseite 64 übertragen wird, während Gleichstromanteile durch den Transformator 58 unberücksichtigt bleiben. Mit anderen Worten werden Gleichstromanteile eines an den Eingängen 66 und 68 anliegenden Taktsignals nicht auf die Sekundärseite 64 transferiert. Die an die Sekundärseite 64 angeschlossenen elektrischen Komponenten werden somit nur von den Wechselspannungsanteilen des Taktsignals 24 beeinflusst.

In dem bevorzugten Ausführungsbeispiel ist unmittelbar an der Sekundärseite 64 des Transformators 58 der Gleichrichter 60 angeordnet. Bei dem Gleichrichter 60 kann es sich um einen einfachen Brückengleichrichter mit vier Dioden handeln. Der Gleichrichter 60 transformiert die an der Sekundärseite 64 abgreifbare Ausgangswechselspannung in eine an den Anschlüssen 70, 72 anliegende Gleichspannung. Ein zwischen den Anschlüssen 70, 72 angeordneter Kondensator 74 glättet und stabilisiert die gleichgerichtete Spannung an den Anschlüssen 70, 72. Ebenso ist zwischen den Anschlüssen 70, 72 eine Erregerspule 76 des Sicherheitsschaltrelais 48 angeordnet. Sofern die vom Transformator 58 übertragene elektrische Leistung ausreichend groß ist, wird die Erregerspule 76 des Sicherheitsschaltrelais 48 durch die an den Anschlüssen 70, 72 anliegende Spannung angezogen.

In dem hier dargestellten bevorzugten Ausführungsbeispiel weist das Sicherheitsschaltrelais 48 nur eine Erregerspule 76 auf. Über einen Doppelanker 78 kann die einzelne Spule 76 zwei voneinander getrennte Kontaktsätze 80a, 80b schalten. Die Arbeitskontakte 80a, 80b sind hier in Serie in einem Stromversorgungspfad 52 angeordnet und weisen vorzugsweise Schließer- und Öffnerkontakte auf. Indem nur eine Erregerspule 76 benötigt wird, um zwei getrennte Kontaktsätze zu schalten, kann das Sicherheitsschaltgerät 14 besonders kleinbauend und insbesondere kostengünstig realisiert werden, da oftmals bei Sicherheitsschaltgeräten die Relais einen hohen Anteil an den Gesamtkosten des Sicherheitsschaltgeräts einnehmen.

Über die Eingänge 66, 68 nimmt das Sicherheitsschaltgerät 14 ein Meldesignal von einem Meldegerät 12 auf. Der Eingang 66 ist hierbei mit dem dritten Anschluss 40 des Meldegeräts 12 verbunden und der Eingang 68 mit dem zweiten Anschluss 36 des Meldegeräts 12. Über den Eingang 66 nimmt das Sicherheitsschaltgerät somit ein vom Meldegerät 12 bereitgestelltes Taktsignal 24 als Meldesignal auf, während am Eingang 68 ein mit dem Meldegerät 12 gemeinsames Massepotenzial aufgenommen wird. Das Meldesignal an dem Eingang 66 wird in der zuvor beschriebenen Weise von dem Transformator 58 transformiert und die daraus resultierende Ausgangswechselspannung vom Gleichrichter 60 und dem Kondensator 74 in eine konstante Gleichspannung umgesetzt. Die Gleichspannung erregt die Spule 76, so dass über den Doppelanker 78 die Arbeitskontakte 80a, 80b angezogen werden und der Strompfad 52 geschlossen wird.

Liegt an den Eingängen 66, 68 jedoch eine Gleichspannung an, beispielsweise aufgrund eines Querschluss innerhalb der hier nicht dargestellten Verbindungsleitung zwischen Meldegerät 12 und Sicherheitsschaltgerät 14, wird keine Ausgangswechselspannung auf der Sekundärseite 64 des Transformators 58 induziert, so dass die Spule 76 nicht angeregt wird und die Schließerkontakte der Arbeitskontakte 80a, 80b geöffnet werden.

Zusätzlich zu den Eingängen 66, 68 umfasst das Sicherheitsschaltgerät 14 in diesem bevorzugten Ausführungsbeispiel weitere Anschlüsse, um einen Starttaster 82 an das Sicherheitsschaltgerät 14 anschließen zu können. Der Starttaster 82 ist einerseits mit dem Eingang 66 und andererseits über die Öffnerkontakte der Arbeitskontakte 80a, 80b mit dem Transformator 58 verbunden. Darüber hinaus ist der Eingang 66 in diesem Ausführungsbeispiel über die Schließerkontakte der Arbeitskontakte 80a, 80b mit dem Transformator 58 verbunden. Durch eine derartige Selbsthaltungsbeschaltung kann verhindert werden, dass die abzusichernde technische Anlage 16 im Fehlerfall von alleine anläuft. Vielmehr ist ein Anlaufen nur möglich, wenn der Starttaster 82 betätigt wird, ein entsprechendes Taktsignal 24 am Eingang 66 anliegt und die Öffnerkontakte (Ruhekontakte) der Arbeitskontakte 80a, 80b geschlossen sind. Sobald die Erregerspule 76 anzieht und die Arbeitskontakte 80a, 80b geschaltet werden, geht das Relais 48 in Selbsthaltung, indem die Schließerkontakte der Arbeitskontakte 80a, 80b geschlossen werden und das Taktsignal am Eingang 66 über die Schließerkontakte zum Transformator 58 geführt wird.

In einem besonders bevorzugten Ausführungsbeispiel hat die Erregerspule 76 eine von der Ansteuerleistung abweichende Halteleistung. Die Ansteuerleistung, bspw. ca. 0,7 Watt, ist die Leistung, die benötigt wird, um den Doppelanker 78 anzuziehen und die Halteleistung, bspw. 0,21 Watt, ist die Leistung, die benötigt wird, um den Doppelanker in der angezogenen Position zu halten. In einem bevorzugten Ausführungsbeispiel kann entweder das Meldegerät 12 oder aber das Sicherheitsschaltgerät 14 selbst nach dem Anziehen des Relais 76 die Leistung des Taktsignals 24 absenken. Das Sicherheitsschaltgerät 14 kann hierfür optional einen Widerstand 84 im Haltekreis vorsehen.

Wird eine Absenkung durch das Meldegerät vorgenommen, stellt der Signalgenerator 30 des Meldegeräts 12 zunächst ein erstes Taktsignal mit einem ersten Effektivwert bereit, und anschließend nachdem der Doppelanker 78 angezogen worden ist, ein zweites Taktsignal mit einem zweiten Effektivwert, wobei der zweite Effektivwert kleiner ist als der erste Effektivwert. Neben einer Energieersparnis bzw. eine Verringerung der Verlustleistung, die von der Spule 76 in Wärme umgesetzt wird, kann darüber hinaus zusätzlich die Sicherheit erhöht werden, da die zum Ansteuern der Spule 76 benötigte Energie nur für einen definierten Zeitraum, beispielsweise ein Zeitraum von 20 bis 200 Millisekunden nach dem Starten der Anlage, bereitgestellt wird. Ein versehentliches Anlaufen der Maschine kann so effektiv verhindert werden.

In dem hier dargestellten Ausführungsbeispiel benötigt das Sicherheitsschaltgerät 14 keine weiteren Anschlüsse zum Aufnehmen einer Versorgungsspannung, da die zum Schalten benötigte Energie ausschließlich aus dem Taktsignal 24 des Meldegeräts 12 entnommen wird. Darüber hinaus benötigt das Sicherheitsschaltgerät 14 keine weiteren elektrischen Komponenten zum fehlersicheren Trennen des Stromversorgungspfads 52. Das gesamte Sicherheitsschaltgerät 14 kann somit sehr kleinbauend realisiert werden. In einem Ausführungsbeispiel kann die gesamte elektrische Schaltungsanordnung auf einer Platine auf der Rückseite eines Doppelankerrelais angeordnet sein. Das gesamte Sicherheitsschaltgerät 14 kann dann eine äußere Form eines Rechtecks haben, dessen Dimensionen kleiner sind als 1 cm x 3 cm x 6 cm.

Neben der kostengünstigen Realisierung erlaubt die Reduzierung der benötigten Komponenten auf ein Minimum eine sehr kompakte Bauweise und damit neue, in der Sicherheitstechnik unübliche Bauformen. Beispielsweise könnte das minimalistische Sicherheitsschaltgerät 14 ohne Gehäuse in einem Schrumpfschlauch angeordnet sein, in den einseitig die Zweidrahtleitung zum Meldegerät 12 hineingeht und ausgangsseitig zwei Anschlüsse für den Stromversorgungspfad 52 vorgesehen sind. Ebenso ist ein einfaches Vergießen mit isolierender Vergussmasse vorstellenbar. Auf diese Weise könnte die neue Sicherheitsschaltungsanordnung besonders gut in kleinen Einzelsystemen intergiert werden.

## Patentansprüche

1. Sicherheitsschaltungsanordnung (10) zum fehlersicheren Abschalten einer elektrisch angetriebenen Anlage (16),
mit einem Sicherheitsschaltgerät (14), das ein Sicherheitsschaltrelais (48) mit einer definierten Ansteuerleistung aufweist und dazu ausgebildet ist, einen Stromversorgungspfad (52) zu der Anlage (16) fehlersicher zu schließen oder zu trennen, und
mit einem Meldegerät (12), das einen Betätiger (26) und einen Signalgenerator (30) aufweist und über eine erste Leitung (20) mit dem Sicherheitsschaltgerät (14) verbunden ist,
wobei der Betätiger (26) zwischen einem ersten definierten Zustand und einem zweiten definierten Zustand wechselbar ist und der Signalgenerator (30) dazu ausgebildet ist, auf der ersten Leitung (20) ein erstes Taktsignal (24) nur dann zu erzeugen, wenn der Betätiger (26) in dem ersten definierten Zustand ist,
**dadurch gekennzeichnet, dass** das Sicherheitsschaltgerät (14) dazu ausgebildet ist, dem ersten Taktsignal (24) ausschließlich aus einem dynamischen Anteil elektrische Leistung größer oder gleich der Ansteuerleistung des Sicherheitsschaltrelais (48) zu entnehmen und in Gleichstrom zum Ansteuern des Sicherheitsschaltrelais (48) umzusetzen.

2. Sicherheitsschaltungsanordnung nach Anspruch 1, wobei das Sicherheitsschaltgerät (14) dazu ausgebildet ist, ausschließlich die dem ersten Taktsignal (24) entnommene Leistung zum Anziehen des Sicherheitsschaltrelais (48) zu verwenden.

3. Sicherheitsschaltungsanordnung nach einem der Ansprüche 1 oder 2, wobei das Meldegerät (12) und das Sicherheitsschaltgerät (14) zusätzlich über eine zweite Leitung (22) verbunden sind und das Meldegerät (12) einen ersten und einen zweiten Anschluss (34, 36) zum Aufnehmen einer Versorgungsspannung (32) sowie einen dritten Anschluss (40) zum Bereitstellen des Taktsignals (24) aufweist, wobei der zweite Anschluss (36) mit der zweiten Leitung (22) verbunden ist und der dritte Anschluss (40) mit der ersten Leitung (20) verbunden ist, um dem Sicherheitsschaltgerät (14) ein gemeinsames Potenzial, insbesondere ein gemeinsames Massepotenzial (38), sowie das erste Taktsignal (24) bereitzustellen.

4. Sicherheitsschaltungsanordnung nach Anspruch 3, wobei der Signalgenerator (30) eingangsseitig zwischen dem ersten Anschluss(34) und dem zweiten Anschluss (36) angeordnet ist und ausgangsseitig mit dem dritten Anschluss (40) verbunden ist.

5. Sicherheitsschaltungsanordnung nach einem der Ansprüche 3 oder 4, wobei der Betätiger (26) einen ersten und einen zweiten Arbeitskontakt (28a, 28b) aufweist und der erste Arbeitskontakt (28a) zwischen dem ersten Anschluss (34) und dem Signalgenerator (30) und der zweite Arbeitskontakt (28b) zwischen dem Signalgenerator (30) und dem dritten Anschluss (40) angeordnet ist.

6. Sicherheitsschaltungsanordnung nach einem der Ansprüche 1 bis 5, wobei der Signalgenerator (30) ein Oszillator, insbesondere ein Sinusoszillator, ist.

7. Sicherheitsschaltungsanordnung nach einem der Ansprüche 1 bis 6, wobei das Sicherheitsschaltgerät (14) zum Entnehmen und Umsetzen der elektrischen Leistung einen Transformator (58) und einen Gleichrichter (60) aufweist, wobei der Transformator (58) primärseitig mit der ersten Leitung (20) verbunden ist und sekundärseitig mit dem Gleichrichter (60), so dass nur Wechselstromanteile des ersten Taktsignals (24) in elektrische Leistung auf der Sekundärseite (64) umgesetzt werden.

8. Sicherheitsschaltungsanordnung nach einem der Ansprüche 1 bis 7, wobei die erste und eine zweite Leitung (20, 22), über die das Meldegerät (12) und das Sicherheitsschaltgerät (14) verbunden sind, je eine Ader einer Zweidrahtleitung (18) sind.

9. Sicherheitsschaltungsanordnung nach einem der Ansprüche 1 bis 8, wobei das Sicherheitsschaltrelais (48) eine zur Ansteuerleistung geringere Halteleistung aufweist und der Signalgenerator (30) dazu ausgebildet ist, ein zweites Taktsignal bereitzustellen, und wobei das Sicherheitsschaltgerät (14) dazu ausgebildet ist, dem zweiten Taktsignal (24) eine elektrische Leistung größer oder gleich der Halteleistung des Sicherheitsschaltrelais (48), jedoch kleiner der Ansteuerleistung des Sicherheitsschaltrelais (48) zu entnehmen und in Gleichstrom zum Halten des Sicherheitsschaltrelais (48) umzusetzen.

10. Sicherheitsschaltungsanordnung nach Anspruch 9, wobei der Signalgenerator (30) dazu ausgebildet ist, beim Wechsel des Betätigers (26) vom zweiten in den ersten Zustand das erste Taktsignal (24) für eine definierte Zeitspanne, insbesondere für 20 bis 200 Millisekunden, bereitzustellen und anschließend das zweite Taktsignal, solange der Betätiger (26) im ersten Zustand ist.

11. Sicherheitsschaltungsanordnung nach einem der Ansprüche 1 bis 8, wobei das Sicherheitsschaltgerät (14) eine zur Ansteuerleistung geringere Halteleistung aufweist und das Sicherheitsschaltgerät (14) dazu ausgebildet ist, nach dem Ansteuern des Sicherheitsschaltrelais (48) eine Energiesenkung des ersten Taktsignals (24) vorzunehmen, so dass das Sicherheitsschaltgerät (14) dem ersten Taktsignal (24) eine elektrische Leistung größer oder gleich der Halteleistung des Sicherheitsschaltrelais (48), jedoch kleiner der Ansteuerleistung entnehmen und in Gleichstrom zum Halten des Sicherheitsschaltrelais (48) umsetzen kann.

12. Sicherheitsschaltungsanordnung nach einem der Ansprüche 1 bis 11, wobei das Sicherheitsschaltrelais (48) ein Doppelankerrelais mit zwei getrennten Kontaktsätzen (80a, 80b), jedoch nur mit einer Spule (76) ist.

13. Sicherheitsschaltgerät (14) für eine Sicherheitsschaltungsanordnung (10) zum fehlersicheren Abschalten einer elektrischen Anlage (16), mit einem Sicherheitsschaltrelais (48) mit einer definierten Ansteuerleistung, das dazu ausgebildet ist, einen Stromversorgungspfad (52) zu der Anlage (16) fehlersicher zu schließen oder zu trennen, und mit einem ersten und einem zweiten Eingang (66, 68) zum Anschließen einer ersten und einer zweiten Leitung (20, 22), über die das Sicherheitsschaltgerät (14) mit einem Meldegerät (12) verbindbar ist und ein erstes Taktsignal (24) aufnehmen kann, **dadurch gekennzeichnet, dass** das Sicherheitsschaltgerät (14) dazu ausgebildet ist, dem ersten Taktsignal (24) ausschließlich aus einem dynamischen Anteil elektrische Leistung größer oder gleich der Ansteuerleistung des Sicherheitsschaltrelais(48) zu entnehmen und in Gleichstrom zum Ansteuern des Sicherheitsschaltrelais (48) umzusetzen.

## Claims

1. Safety circuit arrangement (10) for failsafe shutdown of an electrically driven installation (16), comprising
a safety switching device (14), which has a safety switching relay (48) with a defined actuating power and which is configured to close or disconnect a power supply path (52) to the installation (16) in a failsafe manner, and
a signaling device (12), which has an actuator (26) and a signal generator (30) and which is connected to the safety switching device (14) by a first line (20),
wherein the actuator (26) is interchangeable between a first defined state and a second defined state and the signal generator (30) is configured to generate a first clock signal (24) on the first line (20) only when the actuator (26) is in the first defined state,
**characterized in that** the safety switching device (14) is configured to draw electrical power that is greater than or equal to the actuating power of the safety switching relay (48), exclusively from a dynamic part of the first clock signal (24) and to convert said electrical power to direct current for actuating the safety switching relay (48).

2. Safety circuit arrangement according to claim 1, wherein the safety switching device (14) is configured to use exclusively the power drawn from the first clock signal (24) for energizing the safety switching relay (48).

3. Safety circuit arrangement according to claims 1 or 2, wherein the signaling device (12) and the safety switching device (14) are additionally connected by a second line (22) and the signaling device (12) has a first and a second terminal (34, 36) for receiving a supply voltage (32) and a third terminal (40) for supplying the clock signal (24), wherein the second terminal (36) is connected to the second line (22) and the third terminal (40) is connected to the first line (20) in order to supply a common potential, in particular a common earth potential (38), and the first clock signal (24) to the safety switching device (14).

4. Safety circuit arrangement according to claim 3, wherein the signal generator (30) is arranged such that an input of said signal generator is connected to the first terminal (34) and the second terminal (36) and an output of said signal generator is connected to the third terminal (40).

5. Safety circuit arrangement according to claims 3 or 4, wherein the actuator (26) has a first and a second operating contact (28a, 28b) and the first operating contact (28a) is connected to the first terminal (34) and the signal generator (30) and the second operating contact (28b) is connected to the signal generator (30) and the third terminal (40).

6. Safety circuit arrangement according to any one of claims 1 to 5, wherein the signal generator (30) is an oscillator, in particular a sine-wave oscillator.

7. Safety circuit arrangement according to any one of claims 1 to 6, wherein the safety switching device (14) has a transformer (58) and a rectifier (60) for drawing and converting the electrical power, wherein the primary side of the transformer (58) is connected to the first line (20) and the secondary side of said transformer is connected to the rectifier (60), so that only AC components of the first clock signal (24) are converted to electrical power on the secondary side (64).

8. Safety circuit arrangement according to any one of claims 1 to 7, wherein the first and a second line (20, 22), by which the signaling device (12) and the safety switching device (14) are connected, are each a core of a two-wire line (18).

9. Safety circuit arrangement according to any one of claims 1 to 8, wherein the safety switching relay (48) has a holding power that is lower than the actuating power and the signal generator (30) is configured to supply a second clock signal, and wherein the safety switching device (14) is configured to draw an electrical power from the second clock signal (24) that is greater than or equal to the holding power of the safety switching relay (48) but is lower than the actuating power of the safety switching relay (48) and to convert said electrical power to direct current for holding the safety switching relay (48).

10. Safety circuit arrangement according to claim 9, wherein the signal generator (30) is configured, when the actuator (26) is shifted from the second to the first state, to supply the first clock signal (24) for a defined period of time, in particular for 20 to 200 milliseconds, and then the second clock signal, as long as the actuator (26) is in the first state.

11. Safety circuit arrangement according to any one of claims 1 to 8, wherein the safety switching device (14) has a holding power that is lower with respect to the actuating power and the safety switching device (14) is configured, after actuating the safety switching relay (48), to reduce the energy of the first clock signal (24) so that the safety switching device (14) can draw an electrical power from the first clock signal (24) that is greater than or equal to the holding power of the safety switching relay (48) but is lower than the actuating power and can convert said electrical power to direct current for holding the safety switching relay (48).

12. Safety circuit arrangement according to any one of claims 1 to 11, wherein the safety switching relay (48) is a double-armature relay with two separate contact sets (80a, 80b), but just one coil (76).

13. Safety switching device (14) for a safety circuit arrangement (10) for failsafe shutdown of an electrical installation (16), comprising a safety switching relay (48) having a defined actuating power, said safety switching relay being configured to close or disconnect a power supply path (52) to the installation (16) in a failsafe manner, and a first and a second input (66, 68) for connecting a first and a second line (20, 22), by which the safety switching device (14) can be connected to a signaling device (12) and can receive a first clock signal (24), **characterized in that** the safety switching device (14) is configured to draw electrical power that is greater than or equal to the actuating power of the safety switching relay (48), exclusively from a dynamic part of the first clock signal (24) and to convert said electrical power to direct current for driving the safety switching relay (48).

## Revendications

1. Circuit de sécurité (10) destiné à déconnecter de manière sûre un système à entraînement électrique (16), ledit circuit comprenant
un dispositif de commutation de sécurité (14) qui comporte un relais de commutation de sécurité (48) d'une puissance de commande définie et qui est conçu pour fermer ou couper de manière sûre un chemin d'alimentation électrique (52) vers le système (16), et
un dispositif de signalisation (12) qui comporte un actionneur (26) et un générateur de signal (30) et qui est relié au dispositif de commutation de sécurité (14) par le biais d'une première ligne (20),
l'actionneur (26) pouvant passer entre un premier état défini et un deuxième état défini et le générateur de signal (30) étant conçu pour générer un premier signal d'horloge (24) sur la première ligne (20) seulement lorsque l'actionneur (26) est dans le premier état défini,
**caractérisé en ce que** le dispositif de commutation de sécurité (14) est conçu pour prendre au premier signal d'horloge (24), comportant exclusivement une composante dynamique, une puissance électrique, supérieure ou égale à la puissance de commande du relais de commutation de sécurité (48) et la convertir en courant continu pour commander le relais de commutation de sécurité (48).

2. Circuit de sécurité selon la revendication 1, le dispositif de commutation de sécurité (14) étant conçu pour utiliser exclusivement la puissance prise au premier signal d'horloge (24) pour attirer le relais de commutation de sécurité (48).

3. Circuit de sécurité selon l'une des revendications 1 et 2, le dispositif de signalisation (12) et le dispositif de commutation de sécurité (14) étant en outre reliés par le biais d'une deuxième ligne (22) et le dispositif de signalisation (12) comportant une première et une deuxième borne (34, 36) destinées à recevoir une tension d'alimentation (32) et une troisième borne (40) destinée à délivrer le signal d'horloge (24), la deuxième borne (36) étant reliée à la deuxième ligne (22) et la troisième borne (40) étant reliée à la première ligne (20) afin de doter le dispositif de commutation de sécurité (14) d'un potentiel commun, en particulier d'un potentiel de masse commun (38), et de délivrer le premier signal d'horloge (24).

4. Circuit de sécurité selon la revendication 3, le générateur de signal (30) étant disposé du côté entrée entre la première borne (34) et la deuxième borne (36) et étant relié du côté sortie à la troisième borne (40).

5. Circuit de sécurité selon l'une des revendications 3 et 4, l'actionneur (26) comportant un premier et un deuxième contact de travail (28a, 28b) et le premier contact de travail (28a) étant disposé entre la première borne (34) et le générateur de signal (30) et le deuxième contact de travail (28b) étant disposé entre le générateur de signal (30) et la troisième borne (40).

6. Circuit de sécurité selon l'une des revendications 1 à 5, le générateur de signal (30) étant un oscillateur, en particulier un oscillateur sinusoïdal.

7. Circuit de sécurité selon l'une des revendications 1 à 6, le dispositif de commutation de sécurité (14) comportant un transformateur (58) et un redresseur (60) destinés à prendre et convertir l'énergie électrique, le transformateur (58) étant relié du côté primaire à la première ligne (20) et du côté secondaire au redresseur (60) de sorte que seules les composantes alternatives du premier signal d'horloge (24) sont converties en énergie électrique du côté secondaire (64).

8. Circuit de sécurité selon l'une des revendications 1 à 7, les première et deuxième lignes (20, 22), par le biais desquelles le dispositif de signalisation (12) et le dispositif de commutation de sécurité (14) sont reliés, étant chacune un conducteur d'une ligne bifilaire (18).

9. Circuit de sécurité selon l'une des revendications 1 à 8, le relais de commutation de sécurité (48) ayant une puissance de maintien inférieure à la puissance de commande et le générateur de signal (30) étant conçu pour délivrer un deuxième signal d'horloge, et le dispositif de commutation de sécurité (14) étant conçu pour prendre au deuxième signal d'horloge (24) une puissance électrique supérieure ou égale à la puissance de maintien du relais de commutation de sécurité (48), mais inférieure à la puissance de commande du relais de commutation de sécurité (48) et la convertir en courant continu pour maintenir le relais de commutation de sécurité (48).

10. Circuit de sécurité selon la revendication 9, le générateur de signal (30) étant conçu pour délivrer le premier signal d'horloge (24) pendant un intervalle de temps défini, en particulier pendant 20 à 200 millisecondes, lorsque l'actionneur (26) passe du deuxième état au premier état puis pour délivrer le deuxième signal d'horloge tant que l'actionneur (26) est dans le premier état.

11. Circuit de sécurité selon l'une des revendications 1 à 8, le dispositif de commutation de sécurité (14) ayant une puissance de maintien inférieure à la puissance de commande et le dispositif de commutation de sécurité (14) étant conçu pour réduire l'énergie du premier signal d'horloge (24) après la commande du relais de commutation de sécurité (48) de sorte que le dispositif de commutation de sécurité (14) puisse prendre au premier signal d'horloge (24) une puissance électrique supérieure ou égale à la puissance de maintien du relais de commutation de sécurité (48), mais inférieure à la puissance de commande, et puisse la convertir en courant continu pour maintenir le relais de commutation de sécurité (48).

12. Circuit de sécurité selon l'une des revendications 1 à 11, le relais de commutation de sécurité (48) étant un relais à double induit pourvu de deux ensembles de contacts séparés (80a, 80b), mais d'une seule bobine (76).

13. Dispositif de commutation de sécurité (14) destiné à un circuit de sécurité (10) pour couper un système électrique (16) de manière sûre, ledit dispositif comprenant un relais de commutation de sécurité (48) de puissance de commande définie qui est conçu pour fermer ou couper de manière sûre un chemin d'alimentation électrique (52) vers le système (16), et une première et une deuxième entrée (66, 68) destinées à raccorder une première et une deuxième ligne (20, 22) par le biais desquelles le dispositif de commutation de sécurité (14) peut être relié à un dispositif de signalisation (12) et peut recevoir un premier signal d'horloge (24), **caractérisé en ce que** le dispositif de commutation de sécurité (14) est conçu pour prendre au premier signal d'horloge (24), comportant exclusivement une composante dynamique, une puissance électrique supérieure ou égale à la puissance de commande du relais de commutation de sécurité (48) et la convertir en courant continu pour commander le relais de commutation de sécurité (48).
